# EUROPEAN PATENT SPECIFICATION

(11) **EP 4 325 688 B1**
(45) Date of publication and mention of the grant of the patent: **17.06.2026**
(21) Application number: 22787786.7
(22) Date of filing: 07.01.2022
(51) Int. Cl.: H02J 7/00, H02J 7/04, H01M 10/42, H01M 10/48

(54) **CHARACTERISTIC LEVELING METHOD AND CHARACTERISTIC LEVELING DEVICE**
VERFAHREN ZUR NIVELLIERUNG VON EIGENSCHAFTEN UND VORRICHTUNG ZUR NIVELLIERUNG VON EIGENSCHAFTEN
PROCÉDÉ DE MISE À NOUVEAU DE CARACTÉRISTIQUE ET DISPOSITIF DE MISE À NIVEAU DE CARACTÉRISTIQUE

(30) Priority: 12.04.2021 JP 2021067277
(43) Date of publication of application: 21.02.2024
(73) Proprietor: Murata Manufacturing Co., Ltd., Nagaokakyo-shi, Kyoto 617-8555 (JP)
(72) Inventor: YANAGIHARA, Asuki, Nagaokakyo-shi, Kyoto 617-8555 (JP); TSUTSUMI, Masaomi, Nagaokakyo-shi, Kyoto 617-8555 (JP); ITO, Kinichi, Nagaokakyo-shi, Kyoto 617-8555 (JP); TAKEMURA, Hiroshi, Nagaokakyo-shi, Kyoto 617-8555 (JP); KAWAHARA, Fumikiyo, Nagaokakyo-shi, Kyoto 617-8555 (JP); FUKAHORI, Souko, Nagaokakyo-shi, Kyoto 617-8555 (JP)
(74) Representative: Witte, Weller & Partner Patentanwälte mbB
(86) International application number: PCT/JP2022/000361
(87) International publication number: WO 2022/219858

(56) References cited:
- EP-A2- 3 007 310
- JP-A- 2017 054 684
- JP-A- 2017 147 898
- JP-A- 2020 181 667
- JP-A- 2021 044 950
- US-A1- 2013 015 702

## Description

### TECHNICAL FIELD

The present invention relates to a technique for leveling characteristics of a plurality of used secondary batteries.

### BACKGROUND ART

Patent Document 1 describes a technique for determining whether a used secondary battery is applicable to reconfiguration of an assembled battery, and a reconfiguration method of the assembled battery using the technique.

The technique described in Patent Document 1 acquires an AC internal resistance value of a used secondary battery, compares the AC internal resistance value with a threshold value, and determines application to a reconfigured product.

If the technique described in Patent Document 1 can be applied to the reconfigured product, the used secondary battery is used as an assembled battery reconfigured product. If the technique described in Patent Document 1 cannot be applied to the reconfigured product, the used secondary battery is not used as the assembled battery reconfigured product.

### PRIOR ART DOCUMENT

### PATENT DOCUMENT

Patent Document 1: Japanese Patent Application Laid-Open No. 2015-222195

Further relevant prior art documents are as follows.

Patent Document 2: US2013015702 A1 describes methods for sorting used secondary batteries by measuring their resistance and, optionally, discharge time, classifying them into periods and layers according to deterioration, and assembling rebuilt battery packs from batteries belonging to the same class so that the packs exhibit uniform characteristics.

Patent Document 3: EP3007310 A2 describes a power-storage-system control method and apparatus in which parameter information is obtained from a plurality of assembled batteries, degradation levels are determined and used to group the assembled batteries, and charging and discharging of the groups are controlled according to group-specific priorities and power settings.

### SUMMARY OF THE INVENTION

### Problem to be solved by the invention

However, in the technique described in Patent Document 1, when an assembled battery is reconfigured with a plurality of used secondary batteries determined to be applicable, degradation states vary among the plurality of used secondary batteries constituting the assembled battery. In this case, in the reconfigured assembled battery, performance of the assembled battery is limited to the used secondary battery in the most advanced degradation state.

Specifically, a used secondary battery in the most advanced degradation state is more overused than other used secondary batteries. For this reason, in the reconfigured assembled battery, there arises a problem that the degradation of the used secondary battery in the most advanced degradation state further progresses.

Therefore, an object of the present invention is to provide a technique for reconfiguring an assembled battery using a plurality of used secondary batteries in almost the same degradation state.

### Means for solving the problem

A characteristic leveling method of the present invention includes the steps of: assigning identification information to each of a plurality of used secondary batteries; measuring intrinsic parameters of the plurality of used secondary batteries; calculating degradation degrees of the plurality of used secondary batteries from the intrinsic parameters of the plurality of used secondary batteries and a parameter in a brand-new state of the used secondary battery; determining a target degradation degree adapted to the degradation degrees of the plurality of used secondary batteries; determining an aging condition for each of the plurality of used secondary batteries that sets the degradation degrees of the plurality of used secondary batteries as the target degradation degree; and aging the plurality of used secondary batteries according to the aging condition for each of the plurality of used secondary batteries.

In this method, the degradation degrees of the plurality of used secondary batteries are matched with the target degradation degree.

### Advantageous effect of the invention

According to the present invention, the assembled battery can be reconfigured using the plurality of used secondary batteries in almost the same degradation state.

### BRIEF EXPLANATION OF DRAWINGS

FIG. 1 is a block diagram illustrating a configuration of a characteristic leveling apparatus according to a first embodiment.
FIGS. 2(A), 2(B), 2(C), and 2(D) are diagrams illustrating a concept of characteristic leveling according to the first embodiment.
FIG. 3 is a graph illustrating an example of a degradation curve of a used secondary battery.
FIG. 4 is a flowchart illustrating a characteristic leveling method according to the first embodiment.
FIG. 5 is a block diagram illustrating a configuration of a characteristic leveling apparatus according to a second embodiment.
FIGS. 6(A), 6(B), and 6(C) are diagrams illustrating a concept of characteristic leveling according to the second embodiment.
FIG. 7 is a diagram illustrating the concept of characteristic leveling according to the second embodiment.
FIG. 8 is a diagram illustrating the concept of characteristic leveling according to the second embodiment.
FIG. 9 is a diagram illustrating the concept of characteristic leveling according to the second embodiment.
FIG. 10 is a flowchart illustrating a characteristic leveling method according to the second embodiment.

### MODE FOR CARRYING OUT THE INVENTION

### [First Embodiment]

A characteristic leveling technique for a used secondary battery according to a first embodiment of the present invention will be described with reference to the drawings.

### (Configuration of characteristic leveling apparatus 10)

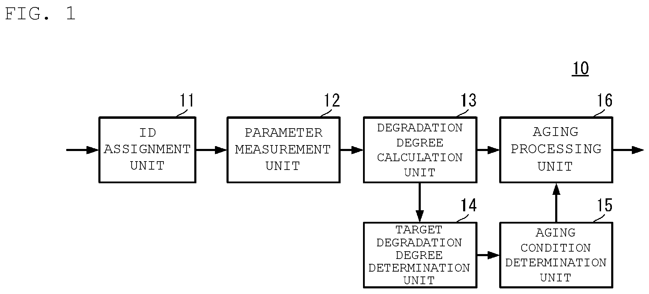

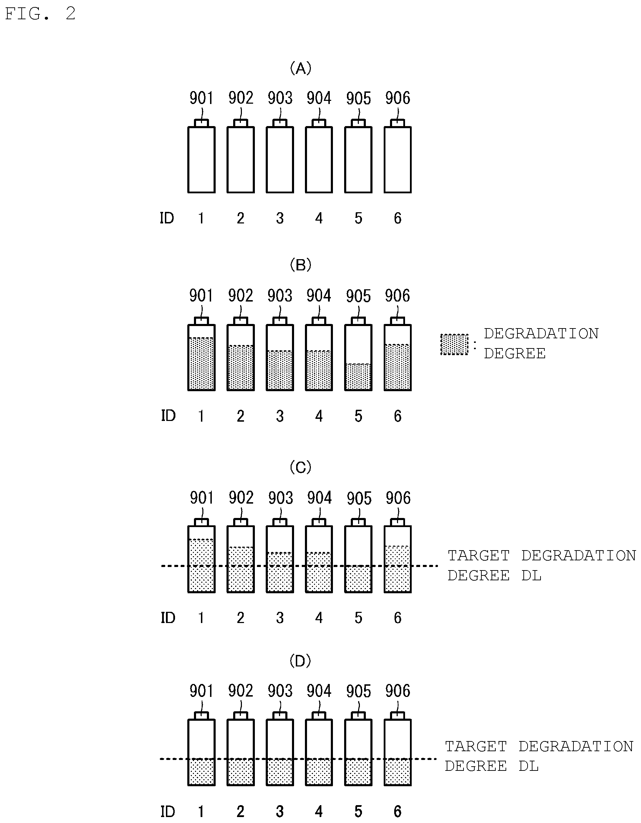

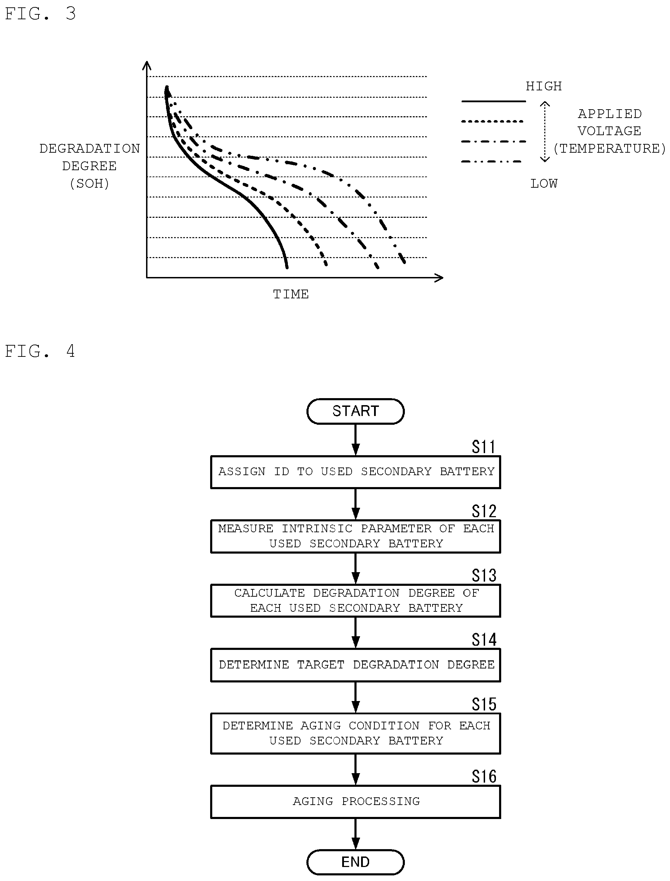

FIG. 1 is a block diagram illustrating a configuration of a characteristic leveling apparatus according to the first embodiment. FIGS. 2(A), 2(B), 2(C), and 2(D) are diagrams illustrating a concept of characteristic leveling according to the first embodiment. FIG. 3 is a graph illustrating an example of a degradation curve of a used secondary battery.

In the first embodiment, an aspect is shown in which six used secondary batteries are inserted, and an assembled battery including the six used secondary batteries is reconfigured with the same degradation degree. The number of used secondary batteries to be inserted and the number of used secondary batteries constituting the assembled battery are not limited thereto. As long as the number of the used secondary batteries to be inserted is the same as the number of the used secondary batteries constituting the assembled battery, other numbers may be used.

As illustrated in FIG. 1, the characteristic leveling apparatus 10 includes an ID assignment unit 11, a parameter measurement unit 12, a degradation degree calculation unit 13, a target degradation degree determination unit 14, an aging condition determination unit 15, and an aging processing unit 16.

The ID assignment unit 11 assigns an ID which is solid identification information to the plurality of inserted used secondary batteries 901 to 906 (used secondary battery 901, used secondary battery 902, used secondary battery 903, used secondary battery 904, used secondary battery 905, and used secondary battery 906).

For example, as illustrated in FIG. 2(A), the ID assignment unit 11 assigns an ID 1 to the used secondary battery 901, an ID 2 to the used secondary battery 902, and an ID 3 to the used secondary battery 903. The ID assignment unit 11 assigns an ID 4 to the used secondary battery 904, an ID 5 to the used secondary battery 905, and an ID 6 to the used secondary battery 906.

For example, the plurality of used secondary batteries 901 to 906 are arranged in a case and conveyed. In housing portions of the plurality of used secondary batteries 901 to 906 in the case, an element capable of storing an ID such as an IC tag is installed corresponding to each housing portion. As a result, the characteristic leveling apparatus 10 can convey the plurality of used secondary batteries 901 to 906 and ID 1 to ID 6, which are in association with each other, in the subsequent processing of each functional unit.

The ID assignment unit 11 sends the plurality of used secondary batteries 901 to 906 to which the respective ID 1 to ID 6 are assigned to the parameter measurement unit 12. The ID assignment unit 11 corresponds to an "identification number assignment unit" of the present invention.

The parameter measurement unit 12 measures intrinsic parameters of the plurality of used secondary batteries 901 to 906. The intrinsic parameter is, for example, an effective capacitance value, an internal resistance value, a charge-discharge curve describing a change in voltage during discharging or charging with a constant current, or the like.

Such an intrinsic parameter can be measured, for example, by disposing an electrode in the housing portions of the plurality of used secondary batteries 901 to 906. The intrinsic parameter may be measured by a separately installed intrinsic parameter measurement device.

The parameter measurement unit 12 sends the plurality of used secondary batteries 901 to 906 for which the intrinsic parameters have been measured to the degradation degree calculation unit 13.

The degradation degree calculation unit 13 stores the intrinsic parameter of a brand new secondary battery of the same type as the plurality of used secondary batteries 901 to 906. The degradation degree calculation unit 13 compares the intrinsic parameters of the plurality of used secondary batteries 901 to 906 measured by the parameter measurement unit 12 with the intrinsic parameter of the brand new one, and calculates the degradation degree of the plurality of used secondary batteries 901 to 906. For example, SOH is used as the degradation degree.

The degradation degree calculation unit 13 associates the calculated degradation degrees of the plurality of used secondary batteries 901 to 906 with ID 1 to ID 6 and outputs the degradation degrees to the target degradation degree determination unit 14. The degradation degree calculation unit 13 sends the plurality of used secondary batteries 901 to 906 to the aging processing unit 16.

The target degradation degree determination unit 14 determines a target degradation degree DL suitable for the degradation degrees of the plurality of used secondary batteries 901 to 906. More specifically, the target degradation degree determination unit 14 detects the lowest degradation degree from the degradation degrees of the plurality of used secondary batteries 901 to 906. That is, the target degradation degree determination unit 14 detects the degradation degree of the used secondary battery in the most advanced degradation state. As illustrated in FIGS. 2(B) and 2(C), the target degradation degree determination unit 14 determines the lowest degradation degree as the target degradation degree DL.

The target degradation degree determination unit 14 outputs the target degradation degree DL to the aging condition determination unit 15. Furthermore, the target degradation degree determination unit 14 associates the degradation degrees of the plurality of used secondary batteries 901 to 906 with ID 1 to ID 6 and outputs the degradation degrees to the aging condition determination unit 15.

The aging condition determination unit 15 determines the aging condition using the degradation degree of the plurality of used secondary batteries 901 to 906, the target degradation degree DL, and the degradation curve of the used secondary battery as illustrated in FIG. 3. More specifically, the aging condition determination unit 15 calculates a difference between the degradation degree and the target degradation degree DL for each of the plurality of used secondary batteries 901 to 906. The aging condition determination unit 15 sets the aging voltage, the aging temperature, and the aging time using the difference between the degradation degree and the target degradation degree DL and the degradation curve.

The degradation curve represents time characteristics of the degradation degree. In other words, the degradation curve represents a change amount (degradation rate) of the degradation degree of the used secondary battery per unit time. As indicated by the degradation curve, the degradation rate is determined by the applied voltage (aging voltage) and the ambient temperature (aging temperature), and the degradation amount is determined by the applied voltage, the ambient temperature, and the aging time.

Therefore, the aging condition determination unit 15 calculates the degradation rate from the degradation curve, and determines the aging voltage, the aging temperature, and the aging time so as to advance to a desired degradation degree based on the degradation rate.

At this time, the aging condition determination unit 15 fixes and sets at least one of the aging voltage, the aging temperature, and the aging time. For example, the aging condition determination unit 15 fixes the aging temperature and the aging time to the plurality of used secondary batteries 901 to 906, and adjusts and sets the aging voltage for each of the plurality of used secondary batteries 901 to 906. As described above, by fixing the aging temperature and the aging time, the aging processing may be performed on the plurality of used secondary batteries 901 to 906 in the same time in one aging furnace. Accordingly, the aging processing can be easily performed.

The aging condition determination unit 15 provides the aging processing unit 16 with the aging condition for each of the plurality of used secondary batteries 901 to 906.

The aging processing unit 16 is, for example, an aging furnace. The aging processing unit 16 ages the plurality of used secondary batteries 901 to 906 under the aging condition given from the aging condition determination unit 15.

Since the aging condition is determined according to the degradation degree and the target degradation degree DL for each of the plurality of used secondary batteries 901 to 906, the degradation degrees of the plurality of used secondary batteries 901 to 906 after the aging processing are substantially the same in the target degradation degree DL.

As a result, the characteristic leveling apparatus 10 can send the plurality of used secondary batteries in almost the same degradation state. Therefore, the assembled battery can be reconfigured using the plurality of used secondary batteries in almost the same degradation state.

In the present embodiment, the target degradation degree DL is matched with the lowest degradation degree. However, the target degradation degree DL may be set to be lower than the lowest degradation degree.

In the present embodiment, an aspect in which all the used secondary batteries 901 to 906 are subjected to the aging processing has been described. However, the used secondary battery having the same degradation degree as the target degradation degree DL may not be subjected to the aging processing.

### (Characteristic leveling method)

FIG. 4 is a flowchart illustrating a characteristic leveling method according to the first embodiment. The detailed contents of each processing in FIG. 4 have been described in the description of the configuration of the characteristic leveling apparatus 10 described above, and detailed description thereof will be omitted below except for required additional description.

The ID assignment unit 11 of the characteristic leveling apparatus 10 assigns ID 1 to ID 6 respectively to the plurality of used secondary batteries 901 to 906 (S11).

The parameter measurement unit 12 of the characteristic leveling apparatus 10 measures the intrinsic parameters of the plurality of used secondary batteries 901 to 906 (S12).

The degradation degree calculation unit 13 of the characteristic leveling apparatus 10 calculates each degradation degree from the intrinsic parameters of the plurality of used secondary batteries 901 to 906 (S13).

The target degradation degree determination unit 14 of the characteristic leveling apparatus 10 determines the target degradation degree DL from the degradation degrees of the plurality of used secondary batteries 901 to 906 (S14).

The aging condition determination unit 15 of the characteristic leveling apparatus 10 determines the aging condition for each of the plurality of used secondary batteries 901 to 906 using the degradation degrees of the plurality of used secondary batteries 901 to 906, the target degradation degree DL, and the degradation curve (S15).

The aging processing unit 16 of the characteristic leveling apparatus 10 performs the aging processing on the plurality of used secondary batteries 901 to 906 under the aging condition determined for each of the plurality of used secondary batteries 901 to 906 (S16).

By using such a method, the degradation states of the plurality of used secondary batteries can be made almost the same. Therefore, the assembled battery can be reconfigured using the plurality of used secondary batteries in almost the same degradation state.

### [Second Embodiment]

A characteristic leveling technique for a used secondary battery according to a second embodiment of the present invention will be described with reference to the drawings. The characteristic leveling technique for the used secondary battery according to the second embodiment is different from the characteristic leveling technique for the used secondary battery according to the first embodiment in that the used secondary batteries of the number that can reconfigure a plurality of assembled batteries are processed. For example, in the example of the present embodiment, a case is shown in which the used secondary batteries of the number (24) that can reconfigure four sets of assembled batteries with six IDs are processed. In the following description, the description of a portion to be subjected to the same process as the characteristic smoothing technique for the used secondary battery of the first embodiment will be simplified or omitted.

### (Configuration of characteristic leveling apparatus 10A)

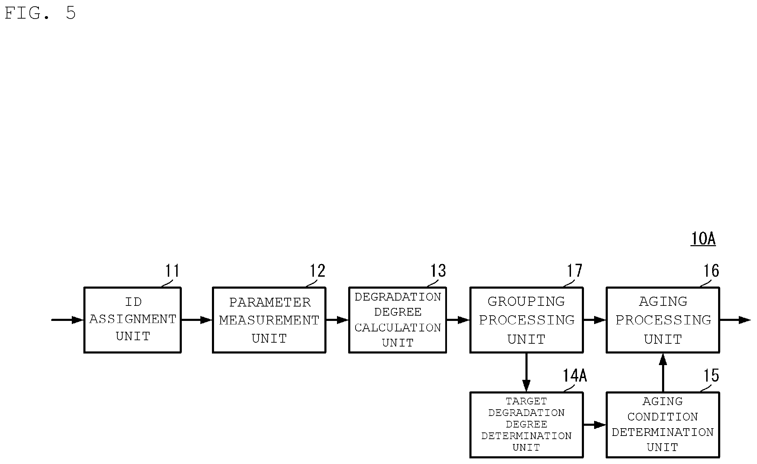

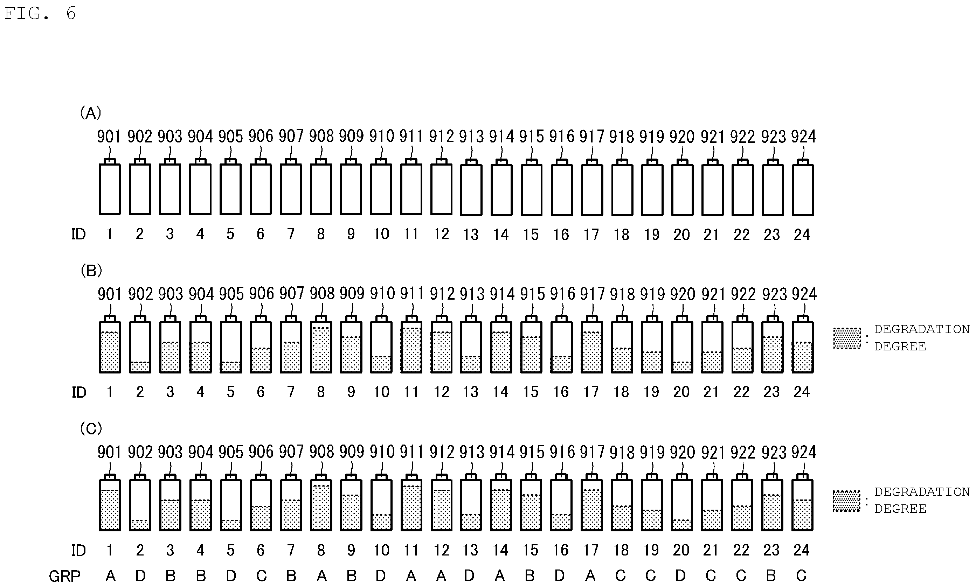

FIG. 5 is a block diagram illustrating a configuration of the characteristic leveling apparatus according to the second embodiment. FIGS. 6(A), 6(B), 6(C), 7, 8, and 9 are diagrams illustrating a concept of characteristic leveling according to the second embodiment.

As illustrated in FIG. 5, the characteristic leveling apparatus 10A includes an ID assignment unit 11, a parameter measurement unit 12, a degradation degree calculation unit 13, a target degradation degree determination unit 14A, an aging condition determination unit 15A, an aging processing unit 16, and a grouping processing unit 17.

The ID assignment unit 11 assigns ID 1 to ID 24 to a plurality of used secondary batteries 901 to 924 (see FIG. 6(A)). The parameter measurement unit 12 measures intrinsic parameters of the plurality of used secondary batteries 901 to 924.

The degradation degree calculation unit 13 calculates the degradation degrees of the plurality of used secondary batteries 901 to 924 (see FIG. 6(B)). The degradation degree calculation unit 13 sends the plurality of used secondary batteries 901 to 924 to the grouping processing unit 17, associates the degradation degrees of the plurality of used secondary batteries 901 to 924 with the ID, and outputs the degradation degree to the grouping processing unit 17.

The grouping processing unit 17 sorts the plurality of used secondary batteries 901 to 924 into a plurality of groups GRPA, GRPB, GRPC, and GRPD according to the degradation degree (see FIG. 6(C)). More specifically, the grouping processing unit 17 rearranges the degradation degrees of the plurality of used secondary batteries 901 to 924 in descending order or in ascending order. The grouping processing unit 17 sorts the degradation degree into groups for each number of the batteries reconfiguring the assembled battery.

For example, in the present embodiment, since the assembled battery is reconfigured with six batteries, six degradation degrees in terms of the degradation degree and six batteries in terms of the used secondary battery are sorted into the groups in descending order of the degradation degree (in the order in which the degradation state does not progress). The sorting here is processing for data, and it is not necessary to move the arrangement of the used secondary batteries 901 to 924.

In the case of FIGS. 6(B) and 6(C), the grouping processing unit 17 sorts the used secondary batteries 901, 908, 911, 912, 914, and 917 with ID 1, ID 8, ID 11, ID 12, ID 14, and ID 17 into the group GRPA having the highest degradation degree. The grouping processing unit 17 sorts the used secondary batteries 903, 904, 907, 909, 915, and 923 with ID 3, ID 4, ID 7, ID 9, ID 15, and ID 23 into the group GRPB having the second highest degradation degree. The grouping processing unit 17 sorts the used secondary batteries 906, 918, 919, 921, 922, and 924 with ID 6, ID 18, ID 19, ID 21, ID 22, and ID 24 into the group GRPC having the third highest degradation degree. The grouping processing unit 17 sorts the used secondary batteries 902, 905, 910, 913, 916, and 920 with ID 2, ID 5, ID 10, ID 13, ID 16, and ID 20 into the group GRPD having the lowest degradation degree.

The grouping processing unit 17 sends the plurality of used secondary batteries 901 to 924 to the aging processing unit 16.

The grouping processing unit 17 associates ID 1 to ID 24 of the plurality of used secondary batteries 901 to 924 and the degradation degrees of the plurality of used secondary batteries 901 to 924 with group identification information of the sorted groups GRPA, GRPB, GRPC, and GRPD and outputs the degradation degrees to the target degradation degree determination unit 14A.

The target degradation degree determination unit 14A determines the target degradation degrees DLA, DLB, DLC, and DLD for each of the groups GRPA, GRPB, GRPC, and GRPD.

More specifically, the target degradation degree determination unit 14A detects the lowest degradation degree from the degradation degrees of the plurality of used secondary batteries in the group. Then, the target degradation degree determination unit 14 determines the lowest degradation degree as the target degradation degree DL of the group.

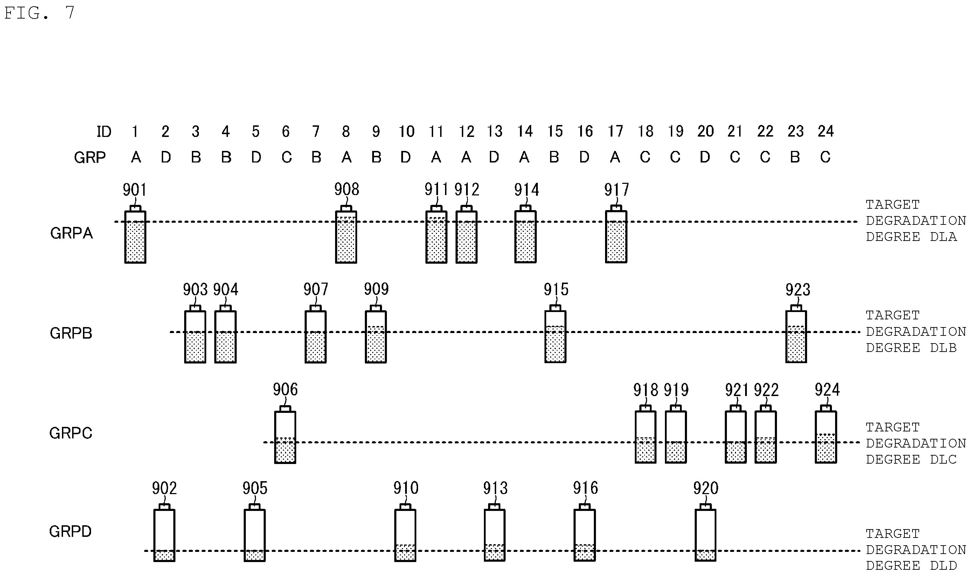

For example, as illustrated in FIG. 7(A), the target degradation degree determination unit 14A detects the lowest degradation degree of the degradation degrees of the used secondary batteries 901, 908, 911, 912, 914, and 917 with ID 1, ID 8, ID 11, ID 12, ID 14, and ID 17, and determines the lowest degradation degree as the target degradation degree DLA of the group GRPA. The target degradation degree determination unit 14A detects the lowest degradation degree of the degradation degrees of the used secondary batteries 903, 904, 907, 909, 915, and 923 with ID 3, ID 4, ID 7, ID 9, ID 15, and ID 23, and determines the lowest degradation degree as the target degradation degree DLB of the group GRPB. The target degradation degree determination unit 14A detects the lowest degradation degree of the degradation degrees of the used secondary batteries 906, 918, 919, 921, 922, and 924 with ID 6, ID 18, ID 19, ID 21, ID 22, and ID 24, and determines the lowest degradation degree as the target degradation degree DLC of the group GRPC. The target degradation degree determination unit 14A detects the lowest degradation degree of the degradation degrees of the used secondary batteries 902, 905, 910, 913, 916, and 920 with ID 2, ID 5, ID 10, ID 13, ID 16, and ID 20, and determines the lowest degradation degree as the target degradation degree DLD of the group GRPD.

The target degradation degree determination unit 14A outputs ID 1 to ID 24 of the plurality of used secondary batteries 901 to 924, the degradation degrees of the plurality of used secondary batteries 901 to 924, the group identification information (groups GRPA, GRPB, GRPC, and GRPD), and the target degradation degrees DLA, DLB, DLC, and DLD for each group to the aging condition determination unit 15A.

The aging condition determination unit 15A determines the aging condition for each of the plurality of used secondary batteries 901 to 924 by using ID 1 to ID 24 of the plurality of used secondary batteries 901 to 924, the degradation degrees of the plurality of used secondary batteries 901 to 924, the group identification information (groups GRPA, GRPB, GRPC, and GRPD), and the target degradation degrees DLA, DLB, DLC, and DLD for each group.

For example, for the plurality of used secondary batteries 901, 908, 911, 912, 914, and 917 belonging to the group GRPA, the aging condition determination unit 15A determines the aging condition of each of the plurality of used secondary batteries 901, 908, 911, 912, 914, and 917 by using each degradation degree and the target degradation degree DLA of the group GRPA. The same applies to the groups GRPB, GRPC, and GRPD, and the description thereof will be omitted.

The aging condition determination unit 15A associates the aging condition determined for each of the plurality of used secondary batteries 901 to 924 with ID 1 to ID 24 and gives the aging condition to the aging processing unit 16.

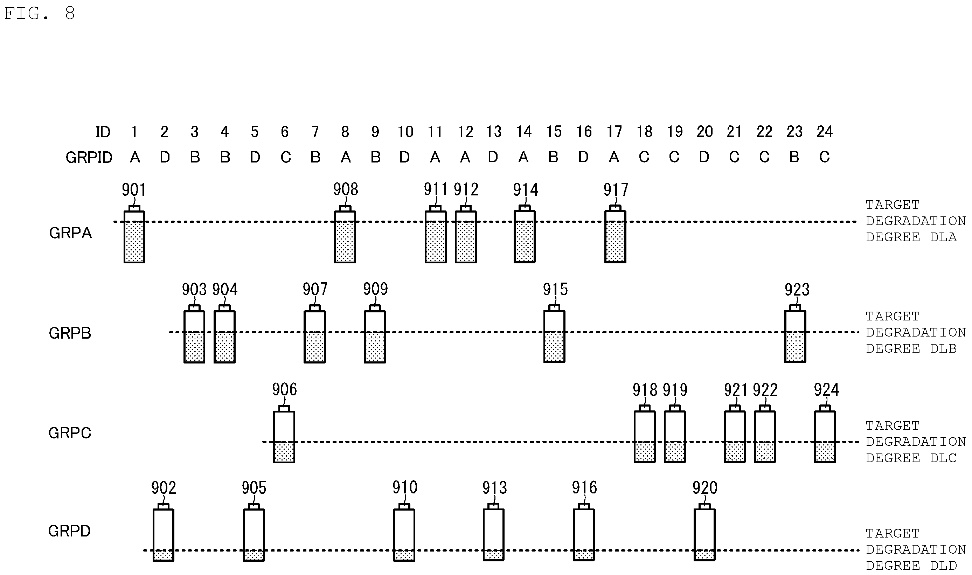

The aging processing unit 16 ages the plurality of used secondary batteries 901 to 924 under the aging condition given from the aging condition determination unit 15. As a result, as illustrated in FIG. 8, the degradation degrees of the plurality of used secondary batteries of each group are almost the same as the target degradation degree of the group. For example, the degradation degrees of the plurality of used secondary batteries 901, 908, 911, 912, 914, and 917 of the group GRPA are almost the same as the target degradation degree DLA of the group GRPA. Similarly, the degradation degrees of the plurality of used secondary batteries 903, 904, 907, 909, 915, and 923 are almost the same as the target degradation degree DLB of the group GRPB. The degradation degrees of the plurality of used secondary batteries 906, 918, 919, 921, 922, and 924 are almost the same as the target degradation degree DLC of the group GRPC. The degradation degrees of the plurality of used secondary batteries 902, 905, 910, 913, 916, and 920 are almost the same as the target degradation degree DLD of the group GRPD.

Thereafter, the plurality of used secondary batteries in units of groups are used for reconfiguring one assembled battery.

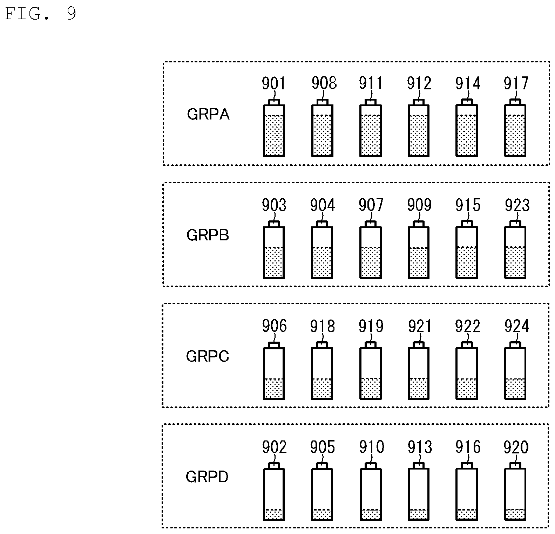

With such a configuration and processing, in the characteristic leveling apparatus 10A, for the plurality of assembled batteries, in the degradation degrees of the plurality of used secondary batteries reconstituting each assembled battery, the degradation states can be made almost the same for each group (see FIG. 9).

In addition, with this configuration and processing, the characteristic leveling apparatus 10A determines the target degradation degree for each group, so that all the used secondary batteries do not have to have the same degradation degree. For example, in the above example, the characteristic leveling apparatus 10A may not match the degradation degrees of the plurality of used secondary batteries of the group GRPA with the target degradation degree of the group GRPD having the highest degradation degree. As a result, the characteristic leveling apparatus 10A can reconfigure the assembled battery while making the degradation degree the same in units of assembled batteries without unnecessarily excessively degrading the used secondary battery.

The characteristic leveling apparatus 10A may include a display that displays the group information of the plurality of used secondary batteries 901 to 924 at an exit of the aging processing unit 16. For example, the characteristic leveling apparatus 10A displays each group identification information in a superimposed manner on an image in which the plurality of used secondary batteries 901 to 924 are arranged. As a result, the operator can easily determine the group to which the plurality of used secondary batteries 901 to 924 belong.

The characteristic leveling apparatus 10A may include a group-wise carrying-out mechanism at a subsequent stage of the aging processing unit 16. In this case, the group-wise carrying-out mechanism refers to the group identification information, and picks up and carries out the plurality of used secondary batteries 901 to 924 for each group. Thus, the operator can easily reconfigure the assembled battery. In addition, the characteristic leveling apparatus 10A may include herein a reconfiguration mechanism for the assembled battery.

### (Characteristic leveling method)

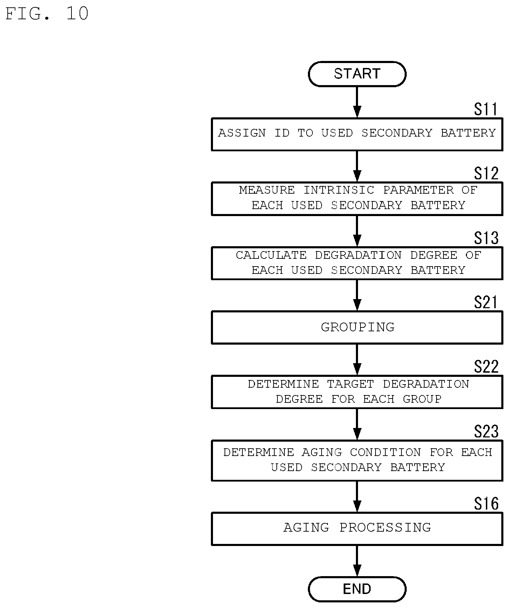

FIG. 10 is a flowchart illustrating a characteristic leveling method according to the second embodiment. The detailed contents of each processing in FIG. 10 have been described in the description of the configuration of the characteristic leveling apparatus 10A described above, and detailed description thereof will be omitted below except for required additional description.

The ID assignment unit 11 of the characteristic leveling apparatus 10A assigns ID 1 to ID 24 respectively to the plurality of used secondary batteries 901 to 924 (S11).

The parameter measurement unit 12 of the characteristic leveling apparatus 10A measures the intrinsic parameters of the plurality of used secondary batteries 901 to 924 (S12).

The degradation degree calculation unit 13 of the characteristic leveling apparatus 10 calculates each degradation degree from the intrinsic parameters of the plurality of used secondary batteries 901 to 924 (S13).

The grouping processing unit 17 of the characteristic leveling apparatus 10A sorts the plurality of used secondary batteries 901 to 924 into the plurality of groups GRPA, GRPB, GRPC, and GRPD according to the degradation degree (S21).

The target degradation degree determination unit 14A of the characteristic leveling apparatus 10A determines the target degradation degrees DLA, DLB, DLC, and DLD for each of the groups GRPA, GRPB, GRPC, and GRPD for the plurality of used secondary batteries 901 to 924 (S22).

The aging condition determination unit 15A of the characteristic leveling apparatus 10A determines the aging condition for each of the plurality of used secondary batteries 901 to 924 using the degradation degrees of the plurality of used secondary batteries 901 to 924, the target degradation degrees DLA, DLB, DLC, and DLD for each of the groups GRPA, GRPB, GRPC, and GRPD, and the degradation curve (S23).

The aging processing unit 16 of the characteristic leveling apparatus 10A performs the aging processing on the plurality of used secondary batteries 901 to 924 under the aging condition determined for each of the plurality of used secondary batteries 901 to 924 (S16)

By using such a method, the degradation states of the plurality of used secondary batteries constituting the plurality of assembled batteries can be made almost the same for each group. Therefore, the plurality of assembled batteries can be reconfigured using the plurality of used secondary batteries in almost the same degradation state.

### DESCRIPTION OF REFERENCE SYMBOLS

10, 10A: Characteristic leveling apparatus
11: ID assignment unit
12: Parameter measurement unit
13: Degradation degree calculation unit
14, 14A: Target degradation degree determination unit
15, 15A: Aging condition determination unit
16: Aging processing unit
17: Grouping processing unit
901-924: Used secondary battery
DL, DLA, DLB, DLC, DLD: Target degradation degree
GRPA, GRPB, GRPC, GRPD: Group

## Claims

1. A characteristic leveling method comprising the steps of:
assigning identification information to each of a plurality of used secondary batteries;
measuring intrinsic parameters of the plurality of used secondary batteries;
calculating degradation degrees of the plurality of used secondary batteries from the intrinsic parameters of the plurality of used secondary batteries and a parameter in a brand-new state of the used secondary battery;
determining a target degradation degree adapted to the degradation degrees of the plurality of used secondary batteries;
determining an aging condition for each of the plurality of used secondary batteries that sets the degradation degrees of the plurality of used secondary batteries as the target degradation degree; and
aging the plurality of used secondary batteries according to the aging condition for each of the plurality of used secondary batteries.

2. The characteristic leveling method according to claim 1, wherein in the aging condition, a degradation rate that is a rate of degradation of the used secondary battery per unit time is set for each of the plurality of used secondary batteries.

3. The characteristic leveling method according to claim 1 or 2, wherein in the aging condition, at least one of an aging voltage, an aging temperature, and an aging time is set.

4. The characteristic leveling method according to any one of claims 1 to 3, wherein the target degradation degree is set to the degradation degree of the used secondary battery in the most advanced degradation state among the plurality of used secondary batteries.

5. The characteristic leveling method according to any one of claims 1 to 3, further comprising a step of sorting the plurality of used secondary batteries into a plurality of groups according to the degradation degree, wherein
the target degradation degree is set for each of the plurality of groups.

6. The characteristic leveling method according to claim 5, wherein the target degradation degree is set to the degradation degree of the used secondary battery in the most advanced degradation state in each group of the plurality of groups.

7. A characteristic leveling apparatus comprising:
an identification number assignment unit that assigns identification information to each of a plurality of used secondary batteries;
a parameter measurement unit that measures intrinsic parameters of the plurality of used secondary batteries;
a degradation degree calculation unit that calculates degradation degrees of the plurality of used secondary batteries from the intrinsic parameters of the plurality of used secondary batteries and a parameter in a brand-new state of the used secondary battery;
a target degradation degree determination unit that determines a target degradation degree adapted to the degradation degrees of the plurality of used secondary batteries;
an aging condition determination unit that determines an aging condition for each of the plurality of used secondary batteries that sets the degradation degrees of the plurality of used secondary batteries as the target degradation degree; and
an aging processing unit that ages the plurality of used secondary batteries according to the aging condition for each of the plurality of used secondary batteries.

8. The characteristic leveling apparatus according to claim 7, further comprising a grouping processing unit that sorts the plurality of used secondary batteries into a plurality of groups according to the degradation degrees of the plurality of used secondary batteries, wherein
the target degradation degree determination unit determines a target degradation degree for each of the groups.

## Patentansprüche

1. Charakteristiknivellierungsverfahren aufweisend die Schritte von:
Zuweisen von Identifikationsinformation zu jeder von einer Vielzahl von verwendeten Sekundärbatterien;
Messen von intrinsischen Parametern der Vielzahl von verwendeten Sekundärbatterien;
Berechnen von Degradationsgraden der Vielzahl von verwendeten Sekundärbatterien aus den intrinsischen Parametern der Vielzahl von verwendeten Sekundärbatterien und einem Parameter in einem neuwertigen Zustand der verwendeten Sekundärbatterie;
Bestimmen eines Ziel-Degradationsgrades angepasst an die Degradationsgrade der Vielzahl von verwendeten Sekundärbatterien;
Bestimmen einer Alterungsbedingung für jede von der Vielzahl von verwendeten Sekundärbatterien, die die Degradationsgrade der Vielzahl von verwendeten Sekundärbatterien als den Ziel-Degradationsgrad einstellt; und
Altern der Vielzahl von verwendeten Sekundärbatterien gemäß der Alterungsbedingung für jede von der Vielzahl von verwendeten Sekundärbatterien.

2. Charakteristiknivellierungsverfahren nach Anspruch 1, wobei in der Alterungsbedingung eine Degradationsrate, die eine Rate der Degradation der verwendeten Sekundärbatterie pro Zeiteinheit ist, für jede von der Vielzahl von verwendeten Sekundärbatterien eingestellt wird.

3. Charakteristiknivellierungsverfahren nach Anspruch 1 oder 2, wobei in der Alterungsbedingung mindestens eines von einer Alterungsspannung, einer Alterungstemperatur und einer Alterungszeit eingestellt wird.

4. Charakteristiknivellierungsverfahren nach einem der Ansprüche 1 bis 3, wobei der Ziel-Degradationsgrad auf den Degradationsgrad der verwendeten Sekundärbatterie in dem am weitesten fortgeschrittenen Degradationszustand unter der Vielzahl von verwendeten Sekundärbatterien eingestellt wird.

5. Charakteristiknivellierungsverfahren nach einem der Ansprüche 1 bis 3, des Weiteren aufweisend einen Schritt des Sortierens der Vielzahl von verwendeten Sekundärbatterien in eine Vielzahl von Gruppen gemäß dem Degradationsgrad, wobei
der Ziel-Degradationsgrad für jede von der Vielzahl von Gruppen eingestellt wird.

6. Charakteristiknivellierungsverfahren nach Anspruch 5, wobei der Ziel-Degradationsgrad auf den Degradationsgrad der verwendeten Sekundärbatterie in dem am weitesten fortgeschrittenen Degradationszustand in jeder Gruppe der Vielzahl von Gruppen eingestellt wird.

7. Charakteristiknivellierungsvorrichtung aufweisend:
eine Identifikationsnummer-Zuweisungseinheit, die Identifikationsinformation zu jeder von einer Vielzahl von verwendeten Sekundärbatterien zuweist;
eine Parametermesseinheit, die intrinsische Parameter der Vielzahl von verwendeten Sekundärbatterien misst;
eine Degradationsgradberechnungseinheit, die Degradationsgrade der Vielzahl von verwendeten Sekundärbatterien aus den intrinsischen Parametern der Vielzahl von verwendeten Sekundärbatterien und einem Parameter in einem neuwertigen Zustand der verwendeten Sekundärbatterie berechnet;
eine Ziel-Degradationsgradbestimmungseinheit, die einen Ziel-Degradationsgrad angepasst an die Degradationsgrade der Vielzahl von verwendeten Sekundärbatterien bestimmt;
eine Alterungsbedingungsbestimmungseinheit, die eine Alterungsbedingung für jede von der Vielzahl von verwendeten Sekundärbatterien bestimmt, die die Degradationsgrade der Vielzahl von verwendeten Sekundärbatterien als den Ziel-Degradationsgrad einstellt; und
eine Alterungsverarbeitungseinheit, die die Vielzahl von verwendeten Sekundärbatterien gemäß der Alterungsbedingung für jede von der Vielzahl von verwendeten Sekundärbatterien altert.

8. Charakteristiknivellierungsvorrichtung nach Anspruch 7, des Weiteren aufweisend eine Gruppierungsverarbeitungseinheit, die die Vielzahl von verwendeten Sekundärbatterien in eine Vielzahl von Gruppen gemäß den Degradationsgraden der Vielzahl von verwendeten Sekundärbatterien sortiert, wobei
die Ziel-Degradationsgradbestimmungseinheit einen Ziel-Degradationsgrad für jede von den Gruppen bestimmt.

## Revendications

1. Procédé de nivellement caractéristique comprenant les étapes consistant à :
l'attribution d'informations d'identification à chacune d'une pluralité de batteries secondaires usagées ;
la mesure de paramètres intrinsèques de la pluralité de batteries secondaires usagées ;
le calcul de degrés de dégradation de la pluralité de batteries secondaires usagées à partir des paramètres intrinsèques de la pluralité de batteries secondaires usagées et d'un paramètre dans un état neuf de la batterie secondaire usagée ;
la détermination d'un degré de dégradation cible adapté aux degrés de dégradation de la pluralité de batteries secondaires usagées ;
la détermination d'une condition de vieillissement pour chacune de la pluralité de batteries secondaires usagées qui définit les degrés de dégradation de la pluralité de batteries secondaires usagées comme degré de dégradation cible ; et
le vieillissement de la pluralité de batteries secondaires usagées en fonction de la condition de vieillissement de chacune de la pluralité de batteries secondaires usagées.

2. Procédé de nivellement caractéristique selon la revendication 1, dans lequel, dans l'état de vieillissement, un taux de dégradation qui est un taux de dégradation de la batterie secondaire usagée par unité de temps est défini pour chacune de la pluralité de batteries secondaires usagées.

3. Procédé de nivellement caractéristique selon la revendication 1 ou 2, dans lequel, dans l'état de vieillissement, au moins l'une parmi une tension de vieillissement, une température de vieillissement et un temps de vieillissement est défini.

4. Procédé de nivellement caractéristique selon l'une quelconque des revendications 1 à 3, dans lequel le degré de dégradation cible est fixé au degré de dégradation de la batterie secondaire usagée dans l'état de dégradation le plus avancé parmi la pluralité de batteries secondaires usagées.

5. Procédé de nivellement caractéristique selon l'une quelconque des revendications 1 à 3, comprenant en outre une étape de tri de la pluralité de batteries secondaires usagées en une pluralité de groupes selon le degré de dégradation, dans lequel
le degré de dégradation cible est défini pour chacun de la pluralité de groupes.

6. Procédé de nivellement caractéristique selon la revendication 5, dans lequel le degré de dégradation cible est réglé sur le degré de dégradation de la batterie secondaire usagée dans l'état de dégradation le plus avancé dans chaque groupe de la pluralité de groupes.

7. Appareil de nivellement caractéristique comprenant :
une unité d'attribution de numéro d'identification qui attribue des informations d'identification à chacune d'une pluralité de batteries secondaires usagées ;
une unité de mesure de paramètres qui mesure des paramètres intrinsèques de la pluralité de batteries secondaires usagées ;
une unité de calcul de degré de dégradation qui calcule des degrés de dégradation de la pluralité de batteries secondaires usagées à partir des paramètres intrinsèques de la pluralité de batteries secondaires usagées et d'un paramètre dans un état neuf de la batterie secondaire usagée ;
une unité de détermination de degré de dégradation cible qui détermine un degré de dégradation cible adapté aux degrés de dégradation de la pluralité de batteries secondaires usagées ;
une unité de détermination d'état de vieillissement qui détermine une condition de vieillissement pour chacune de la pluralité de batteries secondaires usagées qui définit les degrés de dégradation de la pluralité de batteries secondaires usagées comme degré de dégradation cible ; et
une unité de traitement de vieillissement qui fait vieillir la pluralité de batteries secondaires usagées en fonction de la condition de vieillissement de chacune de la pluralité de batteries secondaires usagées.

8. Appareil de nivellement caractéristique selon la revendication 7, comprenant en outre une unité de traitement de regroupement qui trie la pluralité de batteries secondaires usagées en une pluralité de groupes selon les degrés de dégradation de la pluralité de batteries secondaires usagées, dans lequel
l'unité de détermination de degré de dégradation cible détermine un degré de dégradation cible pour chacun des groupes.
